# EUROPÄISCHE PATENTANMELDUNG

(11) **EP 0 881 502 A2**
(43) Veröffentlichungstag der Anmeldung: **02.12.1998**
(21) Anmeldenummer: 98810476.6
(22) Anmeldetag: 22.05.1998
(51) Int. Cl.: G01R 31/01, G01R 31/18, G01R 1/04

(54) **Vorrichtung zur Sicherheits- und Funktionsprüfung elektrischer Apparate**

(30) Priorität: 28.05.1997 CH 1256/97
(71) Anmelder: Alvastone Computer Consultans Limited, London W1X 9DA (GB)
(72) Erfinder:
(74) Vertreter: Gaggini, Carlo, Ing.

(57) **Zusammenfassung**

Die vorliegende Erfindung betrifft eine Vorrichtung zur Messung und Prüfung für die Durchführung von Messungen bezüglich elektrischer Sicherheit und Funktionsprüfungen elektrischer Apparate, insbesondere von Elektro-Haushaltgeräten.

Gemäss dem Stand der Technik sind spezielle Vorrichtungen bekannt zur Ausführung der elektrischen Messungen und der Funktionsprüfungen. Diese Vorrichtungen sind jedoch für die verschiedenen Arten der Verwendung speziell ausgelegt.

Die vorliegende Erfindung schlägt hingegen sehr vielseitig verwendbare Vorrichtungen zur Messung und Prüfung vor, die so ausgelegt sind, dass sie gleichzeitig, oder nacheinander, zur Messung und Prüfung verschiedener Arten von Elektro-Haushaltgeräten oder ähnlicher Apparate auf der gleichen Fabrikationslinie dienen können.

Die Vorrichtung zur Messung und Prüfung gemäss der vorliegenden Erfindung ist dadurch gekennzeichnet, dass sie als auswechselbare Module ausgelegte Messeinheiten (8) aufweist, die mit Verbindungs-Systemen (14) versehen sind, die ein rasches Anschliessen an die Vorrichtung (3) zum Messen und Prüfen erlauben. Dies ermöglicht, dass überaus vielseitige Mess- und Prüf-Abläufe realisiert werden können, die jeder Art von Mess- und Prüf-Problemen angepasst werden können, wobei nur wenige, standardisierte Module (8) verwendet werden.

## Beschreibung

Die vorliegende Erfindung betrifft eine Vorrichtung zur Messung und zur Abnahmeprüfung für die Durchführung von Messungen bezüglich elektrischer Sicherheit und Funktionsprüfungen elektrischer Apparate gemäss dem Oberbegriff des Patentanspruchs 1.

Bei der Serienfabrikation elektrischer Apparate, insbesondere von Elektro-Haushaltapparaten wie Kühlschränke, Waschmaschinen, Haarföhn, Mixer, usw., ist das Problem der Qualitätskontrolle zwischen den Fabrikationsschritten und am Ende des Montagebandes bekannt. Dabei geht es insbesondere um die Endabnahmeprüfung von Elektro-Haushaltgeräten bevor sie verpackt werden. Je nach Auslieferungsland muss das Elektro-Haushaltgerät entsprechend den im betreffenden Land geltenden speziellen Normen. Diese Normen, wie sie die einzelnen Ländern vorschreiben, unterscheiden sich voneinander .

Was die Staaten der EU (Europa-Union) angeht, gelten für den hier betrachteten Fall die Normen CEI-EN, Art. 16.2 und 16.3, die jedem Fachmann auf dem Gebiet bekannt sind. Für andere Staaten gelten davon verschiedene Normen, die der Hersteller berücksichtigen muss.

Die Gross-Serienherstellung von Elektro-Haushatgeräten, das hauptsächliche Anwendungsgebiet der vorliegenden Erfindung, tendiert zunehmend auf kundenspezifische Ausgestaltung der Produkte, d.h. auf die besonderen Wünsche der Kundschaft ausgerichtete Auslegung, so spät als möglich und wenn möglich während der letzten Arbeitsschritte der Fabrikation auszuführen. Damit soll eine flexiblere Fabrikation erreicht und die Lagerzeiten der produzierten Apparate verkürzt werden.

Dies erfordert unter anderem auch, dass Messvorgänge und Abnahmeprüfungen an den Produkten ausgeführt werden müssen, wobei die Anpassungen an die Normen des Absatzlandes schnell durchzuführen sind, so dass keine unerwünschte Fabrikations-Unterbrüche verursacht werden. Darüber hinaus geht heute die Tendenz dahin, dass mehr als ein Modell eines Elektro-Haushaltgeräts auf der gleichen Fabrikationslinie hergestellt und montiert wird, beispielsweise verschiedene Modelle von Waschmaschinen mit unterschiedlichen Eigenschaften. Auch in einem solchen Fall ist erforderlich, dass Vorrichtungen zur Messung und zur Abnahmeprüfung für die Durchführung von Messungen bezüglich elektrischer Sicherheit und Funktionsprüfungen solcher Apparate geschaffen werden, die leicht und wenn möglich mit einfacher Wahl eines Programms durch die Bedienungsperson oder automatisch an das zu prüfende Elektro-Haushaltgrät angepasst werden.

Hinsichtlich der Mess- und Prüfgrössen ist zu bemerken, dass diese je nach Art der zu prüfenden Elektro-Haushaltgeräte unterschiedlich gewählt werden. Im allgemeinen handelt es sich jedoch um Kontrollen und Prüfungen zur Messung der angelegten Spannungen (Elektrische Widerstandsfähigkeit), der Isolation und der Erdung, der Kriechströme zur Erdung, der elektrischen Leistungsaufnahme, d.h. des Energieverbrauchs sowie der Kurzschlussgefahr. Hinzu kommen oft Funktionskontrollen des Gerätes welche die Messung der Temperatur umfassen, die beispielsweise ein Bauteil dabei erreicht, des Drucks in bestimmten Kreisläufen, die Dauer bestimmter Funktionsabläufe (beispielsweise die Zeitspanne innert der das Wasser in einer Waschmaschine eine bestimmte Temperatur erreicht).

Dabei ist zu unterstreichen, dass sich die obenerwähnten Anforderungen nicht nur bei der Fabrikation von Elektro-Haushaltgeräten stellen, sondern ebenso in den Industriebereichen mit grossen Fabrikationsanlagen, in Heizungs- und Klimaanlagen, in Energieerzeugungsanlagen, Kraftwerken, usw. Unzählig sind die Anwendungsbereiche der Mess- und Prüf-Vorrichtungen, die Gegenstand der vorliegenden Erfindung sind.

In der Praxis sind Vorrichtungen zur Messung und Prüfung bekannt für das Durchführen von Messungen bezüglich elektrischer Sicherheit und professioneller Prüfungen an elektrischen Apparaten, welche ein Steuerungsgerät und ein Programmiergerät umfassen, sowie eine Anzahl Messeinheiten und einen Leistungsteil bzw. einen Speisungsteil für elektrischen Strom. Solche Vorrichtungen wurden bisher als spezielle Vorrichtungen für die Messung und Prüfung bestimmter Typen von Elektro-Haushaltgeräten ausgeführt. Das bedeutet, dass für jeden Gerätetyp, beispielsweise eines Elektro-Haushaltgerätes, eine spezielle Vorrichtung geschaffen wurde, welche nur genau die für die Messung und Prüfung eines genau bestimmten Elektrogeräte-Typs erforderlichen Messgeräte enthielt. Es handelte sich also sozusagen um eine Vorrichtung zur Messung und Prüfung für einen einzigen Anwendungsfall, die dementsprechend eine ganze Reihe schwerwiegender Nachteile aufweist, nämlich:
- für jeden Gerätetyp muss für jeden Vorrichtungstyp ein jedesmal verschiedenes Anschluss-Schema erstellt werden;
- normalerweise ist eine grosse Menge an Verbindungen erforderlich;
- uneinheitliche Vorrichtungen, die daher gemäss Definition nicht standardisierbar sind;
- falls Anpassungen oder Reparaturen notwendig werden, muss man direkt beim Kunden eingreifen, wo daher die ganze Vorrichtung ausser Betrieb steht. Deshalb ist der Kunde gezwungen, eine vollständige Reserve-Vorrichtung verfügbar zu halten, damit die Produktion der Fabrikationslinie keinen Unterbruch erleidet;
- die Zertifizierung solcher Vorrichtungen wird schwierig, insbesondere weil jede Vorrichtung von der vorhergehenden verschieden ist. Zwar können die einzelnen Komponenten einer solchen Vorrichtung zertifiziert werden, aber schwerlich die vollständige Vorrichtung.

Zweck der vorliegenden Erfindung ist es daher, die Nachteile gemäss dem Stand der Technik zu vermeiden und eine Vorrichtung zum Messen und Prüfen vorzuschlagen, die dem Oberbegriff des Anspruchs 1 entspricht, und mit der die folgenden Ziele erreicht werden können:
- einzelne Mess-Einheiten sollen auf Lager gehalten werden können;
- die Messeinheiten sollen einzeln zertifiziert werden können;
- die Mess-Einheiten sollen beliebig gemischt zusammengestellt werden können, so dass die Vorrichtung zum Messen und Prüfen an die Anforderungen für irgend ein zu prüfendendes Elektrogerät, insbesondere ein Elektro-Haushaltgerät, angepasst werden kann;
- Die Verbindungen in der Vorrichtung zum Messen und Prüfen sollen reduziert werden;
- die Mess-Einheiten als einzelne Module sollen unabhängig von einander verwendbar sein, so dass sie im Fall einer Störung oder einer Beschädigung zur Reparatur an den Hersteller geschickt werden können;
- die Anzahl der von der Vorrichtung auszuführenden Funktionen der Vorrichtung zum Messen und Prüfen soll in einfacher Weise verändert werden können, indem einzelne Mess-Einheiten zugefügt oder weggenommen werden;
- die gesamte Vorrichtung zum Messen und Prüfen soll unabhängig von der Anzahl und von der Art der effektiv für die Abnahmeprüfung eines bestimmten Elektrogerätes eingesetzten Mess-Einheiten zertifiziert werden können;
- die Vorrichtung zum Messen und Prüfen soll anhand eines Katalogs der Komponenten entsprechend den Wünschen des Kunden zusammengestellt werden können.

Diese Ziele werden alle mittels einer Vorrichtung gemäss dem kennzeichnenden Teil des Anspruchs 1 zum Messen und Prüfen erreicht für die Durchführung von Messungen bezüglich elektrischer Sicherheit und Funktionsprüfungen elektrischer Apparate, insbesondere Elektro-Haushaltgeräte.

Dank der Tatsache, dass die Mess-Einheiten als auswechselbare Module ausgebildet sind und mit Anschlusseinrichtungen versehen sind, mittels derer sie schnell an die Vorrichtung zum Messen und Prüfen angeschlossen werden können, und da sie in dieser Vorrichtung oder in separaten anderen Vorrichtungen zum Messen und Prüfen untereinander ausgetauscht werden können, ist es möglich, allgemein verwendbare Vorrichtungen zum Messen und Prüfen zu schaffen, die mit anderen Vorrichtungen des gleichen Typs kombinierbar sind. Dies erlaubt die Einrichtung ausserordentlich vielseitiger Vorrichtungen zum Messen und Prüfen im Fabrikationsbetrieb selbst, die allen Verwendungszwecken rasch angepasst werden können, so dass auch die komplexesten Probleme der Fabrikationssteuerung gelöst werden können, beispielsweise wenn auf der gleichen Fabrikationsstrasse verschiedene Elektrogeräte produziert werden (insbesondere wenn die einzelnen Geräte den Normen der jeweiligen Auslieferungsländer angepasst werden müssen), ohne dass Eingriffe in die Gestaltung der Vorrichtung selbst erforderlich werden. Da die Vorrichtung zum Messen und Prüfen über alle erforderlichen Module verfügen kann, auch in mehrfacher Ausführung, handelt es sich bloss noch um eine Frage der Programmierung, d.h. der Software, zur Anpassung des Verwendung der einzelnen Module in den durchzuspielenden Test-Programmen. Die erfindungsgemässe Vorrichtung bietet somit die grössten Kombinationsmöglichkeiten der Module, um mittels der Steuerungs- und Programmiereinheit eine praktisch unbegrenzte Sequenz verschiedener Arbeitsschritte realisieren zu können. Zur Erfüllung der Aufgabe genügt es, die erforderlichen auswechselbaren Module, von denen das Fabrikationswerk eine genügende Reserve auf Lager hält, auszuwählen und in die Vorrichtung einzuschieben. Das Fabrikationswerk ist somit in der Lage, jederzeit den immer verschiedeneren Fabrikations-Erfordernissen nachzukommen und damit den Forderungen nach stets steigender Anpassungsfähigkeit an den Markt gerecht zu werden. Weitere wichtige Vorteile des modularen Aufbaus sind bereits weiter oben dargelegt worden und sind jedem Fabrikationsfachmann klar, so dass an dieser Stelle keine weiteren besonderen Erklärungen nötig sind. Sie sind jedoch Gegenstand der abhängigen Patentansprüche, die im Folgenden unter Bezugnahme auf einige praktische Anwendungsbeispiele der vorliegenden Erfindung besser beschrieben werden können, die in den entsprechenden Figuren und einigen Arbeitsablauf-Schemen dargestellt sind.

Die Figuren zeigen:
- Fig. 1: das Ende einer Fabrikationslinie für Elektro-Haushaltgeräte mit der erfindungsgemässen Vorrichtung zur Messung und Prüfung für die Durchführung der abschliessenden Messungen und Abnahmeprüfungen;
- Fig. 2: eine Ansicht einer ersten Ausführungsform gemäss der beanspruchten Erfindung mit der Steuerungs- und Programmierungs-Einheit in Form eines Mikroprozessors (LCD);
- Fig. 3: eine Ansicht einer der in der Fig. 2 gezeigten Vorrichtung ähnliche Vorrichtung, bei der als Steuerungs-Einheit ein Personal Computer (PC) verwendet ist;
- Fig. 4: ein Detail einer Mess-Einheit, wie sie in der erfindungsgemässen Vorrichtung Verwendung findet;
- Fig. 5: ein Mehrfach-Prüfinstrument, das mit einer Steuerungs-Einheit mit Mikroprozessor (LCD) ausgerüstet ist wie jene in der Fig. 2 und auf der eine Reihe von Mess-Einheiten Verwendung findet wie auf jener der Fig. 4;
- Fig. 6: ein einzelnes Prüfinstrument, das dem in der Fig. 4 verwendeten gleicht, aber mit nur einer einzigen Mess-Einheit gemäss der Fig. 4.
- Fig. 7: ein Beispiel eines Schemas des Mess- und Prüf-Arbeitsablaufs, wie er mittels der erfindungsgemässen Vorrichtung bei der Fabrikation von Elektro-Haushaltgeräten realisiert werden kann;
- Fig. 8: ein weiteres Beispiel eines Schemas des Mess- und Prüf-Arbeitsablaufs, wie er mittels der erfindungsgemässen Vorrichtung bei der Herstellung von Klimageräten realisiert werden kann.

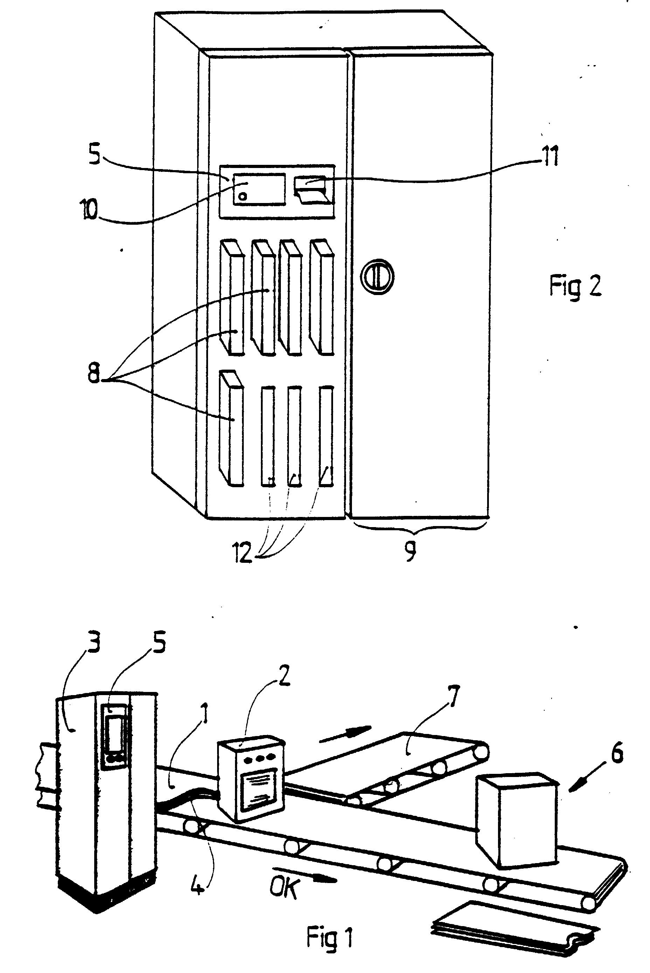

In der Fig. 1 ist im Sinn eines Beispiels eine typische Anwendungsform der Erfindung gezeigt: Es handelt sich um das Endstück einer Fabrikationslinie für Elektro-Haushaltgeräte, z.B. von Sparherden. Auf dem Förderband 1 wird das für die Abnahmeprüfung vorbereitete Elektro-Haushaltgerät 2, im vorliegenden Fall ein Sparherd, zur Vorrichtung 3 zur Messung und Prüfung geführt, bevor es verpackt wird. Das Elektro-Haushaltgerät 2 wird hier mittels einer Verbindung 4, die Elektrokabel und/oder andere Verbindungsmittel enthält, an die Vorrichtung 3 zur Messung und Prüfung angeschlossen, damit eine Reihe von Kontrolloperationen durchgeführt werden können, die im Voraus in einer in der Vorrichtung 3 zur Messung und Prüfung vorgesehenen Steuerungs- und Programmierungs-Einheit 5 festgelegt und programmiert sind. Die Bedienungsperson muss nun die das zu prüfende Elektro-Haushaltgerät 2 mit der Vorrichtung 3 zur Messung und Prüfung verbinden, die vorgängig programmiert und, wie es im Folgenden genauer erklärt wird, mit allen für diesen Zweck erforderlichen Mess-Einheiten ausgerüstet worden war, und muss das Mess-und Prüf-Programm starten.

Besteht das Elektro-Haushaltgerät die Abnahmeprüfung erfolgreich, d.h. wenn alle gemessenen elektrischen wie mechanischen Grössen den Normen gerecht werden, nach welchen die Kontrolle ausgelegt wurde - und diese Normen können je nach Auslieferungsland erheblich voneinander abweichen - so wird es auf dem Förderband 1 zur Verpackungsstation 6 weiterbefördert, wo es in eine geeignete Schachtel verpackt und allenfalls mit den unerlässlichen Adressangaben versehen zur Spedition weiterbefördert wird. Erreicht jedoch das Elektro-Haushaltgerät 2 in irgendeiner seiner technischen Eigenschaften - die sowohl elektrischer als physikalischer oder mechanischer Natur sein kann, wie beispielsweise das Nicht-Erreichen einer bestimmten Temperatur innert einer vorgegebenen Zeitspanne, oder ein ungenügender Druck in einem hydraulischen Kreislauf - die im Abnahme-Prüfprogramm geforderte Minimalbedingung nicht, so wird das Gerät auf ein Förderband 7 für Ausschuss-Geräte geschoben, vorzugsweise mit einem von der Steuerungs- und Programmierungs-Einheit ausgedruckten Prüfprotokoll, aus dem hervorgeht, aus welchen Gründen das Elektro-Haushaltgerät 2 aus der Fabrikationslinie herausgenommen wurde. Dies erlaubt nachfolgend eine weitere Behandlung und gegebenenfalls eine Behebung de Defektes.

Das Problem bei einer solchen Fabrikationslinie besteht darin , wie bereits weiter oben angetönt, und welchem die vorliegende Erfindung Abhilfe schaffen soll, dass die Elektro-Haushaltgeräte 2 verschiedene Eigenschaften aufweisen können, obwohl sie auf der gleichen Fabrikationslinie hergestellt worden sind, da heute zunehmend versucht wird, auf der gleichen Fabrikationslinie parallel nebeneinander verschiedene Typen von Elektro-Haushaltgeräten herzustellen, beispielsweise verschiedene Modelle von Sparherden, mit 3 oder mit 4 elektrischen Kochplatten, und vor allem Geräte für verschiedene Bestimmungsländer, in denen verschiedene Bedingungen herrschen, sei es bezüglich Funktion (beispielsweise verschiedene Netzspannungen) oder (was noch häufiger vorkommt) bezüglich verschiedenartiger Normen für die Abnahmeprüfung. Die Vorrichtung 3 zur Messung und Prüfung muss deshalb in der Lage sein, die Abnahmeprüfungen so anpassen zu können - sei es aufgrund eines direkten Eingriffs seitens der Bedienungsperson, die den Ablauf der Abnahmeprüfungen an die verlangten Bedingungen anpasst oder sei es aufgrund der Einwirkung von Sensoren, die in der Lage sind, den Typ des zu prüfenden Elektro-Haushaltgerätes automatisch zu erkennen - dass sie den besonderen Bedingungen entsprechen, die für das zu prüfende Gerät gefordert sind, und dies ohne Zeitverlust und Produktionsverzögerungen.

Bereits an dieser Stelle sei klargestellt, dass die Vorrichtung 3 zur Messung und Prüfung über die obenerwähnte Aufgabe hinaus, die letztlich den Zweck der vorliegenden Erfindung bildet, gegebenenfalls, und insbesondere wenn sie mit einem Personal Computer (PC) versehen ist, wie dies in einer bevorzugten Ausführungsform der Erfindung vorgesehen ist, auch weitere Aufgaben übernehmen kann, die mit Hilfe geeigneter Software auf dem PC gelöst werden können. Beispielsweise kann die Vorrichtung über das Ausdrucken eines vollständigen Prüfprotokolls hinaus auch personalisierte Speditions-Etiketten für das Elektro-Haushaltgerät ausdrucken, das Kundenverzeichnis nachführen, die Produktionsstatistiken auf dem neusten Stand halten, usw. Unzählige Möglichkeiten bestehen zur Anwendung von Kontrollprogrammen, die insbesondere mit Hilfe eines Personal Computers mittels Softwarelösungen realisiert werden können: Die vorliegende Erfindung befasst sich allerdings nur mit den Möglichkeiten der Messung und Prüfung, die eine solche Vorrichtung bietet, und überlässt spezialisierten Programmierern die Aufgabe, alle Möglichkeiten voll auszuschöpfen, die die Verwendung eines programmierbaren PC in der erfindungsgemässen Vorrichtung bietet. Die vorliegende Erfindung befasst sich daher nur mit der Hardware einer solchen Vorrichtung zur Messung und Prüfung auf welcher die Entwicklung und Anwendung einer mehr oder weniger weit getriebenen Programmierung einer Steuerungs- und Programmierungs-Einheit 5 basiert.

In der Fig. 2 ist eine vergrösserte Darstellung einer ersten bevorzugten Ausführungsform der erfindungsgemässen Vorrichtung 3 zur Messung und Prüfung gezeigt. Diese Vorrichtung 3 besteht im Wesentlichen aus drei Elementen, nämlich aus einer Steuerungs- und Programmierungs-Einheit 5, aus einer Reihe von Mess-Einheiten 8, die als auswechselbare und mit einem Anschluss-System versehene Module ausgebildet sind, die den schnellen Anschluss an die Vorrichtung 3 zur Messung und Prüfung erlauben, sowie aus einem Leistungsteil 9, der alle Elemente enthält, die für die Speisung sowohl der Mess-Module 8 als auch der Steuerungs- und Prüfungs-Einheit 5 erforderlich sind. Der Leistungsteil ist in einem separaten Abteil des Schaltschranks der ganzen Vorrichtung 3 eingeschlossen und ist nicht im Detail dargestellt, da dessen Elemente jedem Fachmann auf dem Gebiet bekannt sind. Im besonderen Fall, der in der Fig. 2 dargestellt ist, besteht die Steuerungs- und Programmierungs-Einheit aus einem programmierbaren Mikroprozessor 10 zur Durchführung bestimmter Sequenzen von Arbeitssschritten und ist mit einem Druckwerk 11 versehen, das die Resultate durchgeführter Prüfungen und Messungen z.B. auf einem Papierstreifen ausdruckt.

Bezüglich der Mess-Einheiten 8, deren modulare Ausbildung den eigentlichen Kerngedanken der vorliegenden Erfindung ausmacht, ist anzumerken, dass in der Fig. 2 im Sinne eines Beispiels 8 Aufnahmestellen 12 für die Aufnahme von entsprechenden Einheiten 8 vorgesehen sind, von denen jedoch nur 5 (vier in der oberen und eines in der unteren Reihe) mit einer Mess- und Prüf-Einheit 8 besetzt sind. Dies bedeutet, dass im hier dargestellten Fall lediglich fünf Messeinheiten 8 erforderlich waren, von denen einige untereinander gleich sein können, um das vorgesehene Mess- und Prüf-Programm fahren zu können. Dennoch ist zu unterstreichen, dass die Anzahl von 8 Aufnahmestationen 12 lediglich einen Hinweis darstellt, und dass auch die Anzahl der Mess-Einheiten oder Module 8 lediglich im Sinn eines Beispiels gewählt wurden. In der praktischen Anwendung ist die erfindungsgemässe Vorrichtung 3 zur Messung und Prüfung mir einer grösseren Anzahl von Aufnahmestationen (z.B. 16 oder 32) versehen und verwendet eine wesentlich grössere Zahl von Messeeinheiten 8.

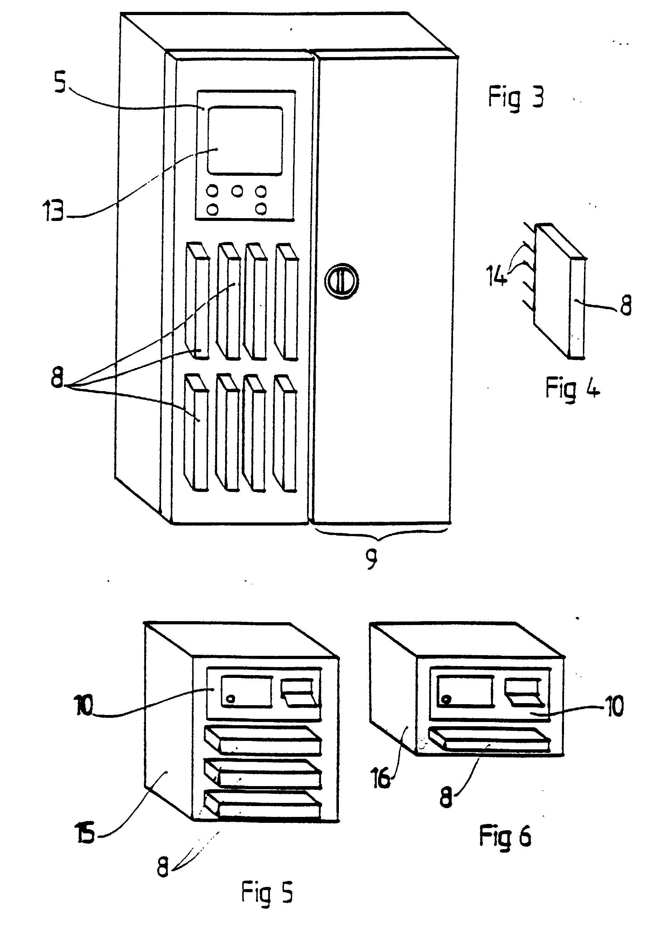

In der Fig. 3 ist eine zweite bevorzugte Ausführungsform der erfindungsgemässen Vorrichtung zur Messung und Prüfung dargestellt, die der in der Fig. 2 dargestellten gleicht, aber mit einem Personal Computer (PC) 13 als Steuerungs- und Programmierungs-Einheit versehen ist, wodurch dem Betreiber gegenüber der Lösung gemäss der Fig. 2 wesentlich mehr Möglichkeiten der Programmierung offenstehen. Die Verwendung eines Personal Computers (PC) erlaubt nicht nur die Programmierung einer Anzahl von Mess- und Kontroll-Arbeitsschritten der elektrischen und mechanischen Werte in viel grösserem Umfang im Vergleich mit der Lösung mit einem Mikroprozessor, sondern erlaubt auch, der Vorrichtung zur Messung und Prüfung eine nach Bedarf erweiterbare Reihe weiterer Funktionen der Produktions-Steuerung und -Ueberwachung zuzuweisen, wie beispielsweise die vollständige Freiheit, von einem Typ Elektro-Haushaltgerät oder Apparat zum anderen zu wechseln, die Durchführung komplizierter Programme zur Analyse der Defekte, die Gewinnung beliebiger Statistik-Werte im Zusammenhang mit der Fabrikation oder der Vermarktung des Produktes, usw. Mit Hilfe eines PC kann der Betreiber der erfindungsgemässen Vorrichtung sodann mit einer entsprechenden Wahl der Anzahl und der Art der Mess-Einheiten 8 und mit einer entsprechenden Programmierung seines PC sein Arbeitsprogramm den verschiedensten Anwendungsformen anpassen und die Maschine eine praktisch unbegrenzte Zahl von Kontrollfunktionen, Prüfungen und Betrieb des fertigen Produktes ausführen lassen. Angenommen, die Vorrichtung sei mit einer genügenden Anzahl Aufnahmestationen 12 für die Messeinheiten 8 ausgerüstet - und die praktische Erfahrung hat gezeigt, dass 16 oder 32 Aufnahmestationen 12 eine optimale Anzahl für die Lösung des grössten Teils der heute bekannten Mess- und Prüf-Probleme darstellen - kann die Bedienungsperson unter Ausnützung der Kapazität eines normalen Personal Computers (PC) 13 ihr eigenes, den besonderen Eigenheiten ihres Fabrikationsbetriebs und dessen Produkten angepasstes Arbeitsprogramm aufstellen. Aus der Praxis ist bekannt, dass eigentlich keine optimalen generellen Programme für die Messung und Prüfung bestehen, sondern bloss Programme, die in Funktion der besonderen Arbeitsbedingungen optimiert sind, unter denen die Fabrikation im Werk zu betreiben ist. Dabei handelt es sich beim Durchführen der Mess- und Prüf-Operationen immer um ein spezielles Optimierungsproblem, da in jedem Fabrikationswerk eine besondere Fabrikationsphilosophie herrscht, der Rechnung zu tragen ist. Die erfindungsgemässe Vorrichtung zur Messung und Prüfung hat ja gerade den Zweck, den Kunden von den Einschränkungen zu befreien, die mit der starren Struktur der bisherigen Vorrichtungen, die gemäss dem Stand der Technik bekannt sind, verbunden sind, und die die Verwendung von speziell zur optimalen Durchführung einzelner Kontrolloperationen ausgelegten Maschinen vorsahen, beispielsweise zur Prüfung eines bestimmten Typs eines Elektro-Haushaltgerätes, indem ermöglicht wird, dass jenes Programm für Messung, Prüfungen, Betrieb, usw. ausgewählt werden kann, das den vorliegenden. Arbeitsbedingungen am besten angemessen sind. In diesem Sinne erlaubt die Verwendung eines in der erfindungsgemässen Vorrichtung integrierten Personal Computers (PC) 13 der Bedienungsperson, seine Auswahlmöglichkeiten wesentlich verbreitert gegenüber der Lösung, die im Rahmen der vorliegenden Erfindung vorgesehen ist, bei der ein Mikroprozessor 10 verwendet wird.

Aus der Fig. 4 ist ersichtlich, wie die Messeinheit 8, die erfindungsgemäss in Gestalt eines auswechselbaren Moduls ausgebildet ist, mit Anschluss-Systemen 14 versehen ist, die ein rasches Anschliessen an die Vorrichtung 3 zum Messen und Prüfen erlaubt.

Die Wahl der Art des Anschluss-Systems 14 hängt natürlich von der Art der anzuschliessenden Verbindungen ab: Wenn es sich um Verkabelungen für elektrische Signale handelt, werden Stecker-Kontakte verwendet, währenddem die Verbindungen für andere Messmittel, beispielsweise für den Transport von Flüssigkeiten, kommen beispielsweise Schnellanschlüsse mit Gewinden zur Anwendung, die auf dem Markt erhältlich sind.

In den Figuren 4 und 5 ist die Anwendungsmöglichkeit der modularen Einheiten 8 für Messungen in besonderen Prüfinstrumenten 15 oder 16 dargestellt, die nur zur Durchführung genau festgelegter Prüf- oder Kontroll-Operationen bestimmt sind: Dies soll zeigen, wie die modularen, austauschbaren Einheiten 8 auch ausserhalb der erfindungsgemässen Vorrichtung zur Messung verwendet werden können, so dass sich die Anwendungsmöglichkeiten breiter und auch wirtschaftlich interessanter werden. In der Praxis wird sich das Fabrikationswerk mit einer bestimmten Reserve von Modulen 8 ausrüsten, die in verschiedenster Weise verwendet werden und unter anderem auch als Reservemodule dienen, die im Fall von Defekten in einem eingesetzten Modul eingeschoben werden. Dank dieser Möglichkeit, jederzeit Reserve-Module 8 verfügbar zu haben, verringert sich das Risiko von Produktionsunterbrüchen der Fabrikationslinie wegen Funktionsstörungen der erfindungsgemässen Vorrichtung zur Messung und Prüfung.

Bezüglich der Auslegung der einzelnen Module 8, die beispielsweise für die elektrische Widerstandsfähigkeit, der Isolation und die durchgehende Wirksamkeit der Erdung, der ein- und/oder dreiphasigen Leistungsaufnahme, des elektrischen Widerstandes oder der elektrischen und physikalischen Grössen vorgesehen sind, enthalten die Ansprüche 7 bis 11 die für den Fachmann auf dem Gebiet erforderlichen Angaben, aufgrund derer solche Module für spezielle Funktionen optimal realisiert werden können. Dabei ist klar, dass diese Angaben nicht erschöpfend sind, noch die Möglichkeiten, Mess-einheiten oder Module 8 mit bestimmten Funktionen zu schaffen, noch die Möglichkeiten, ähnliche spezifische Module auszulegen. Es geht in der Darstellung eher darum, bevorzugte Ausführungsbeispiele anzugeben, die dank des unaufhaltsamen Fortschreitens der technischen Entwicklung einer kontinuierlichen Weiterentwicklung unterworfen sind.

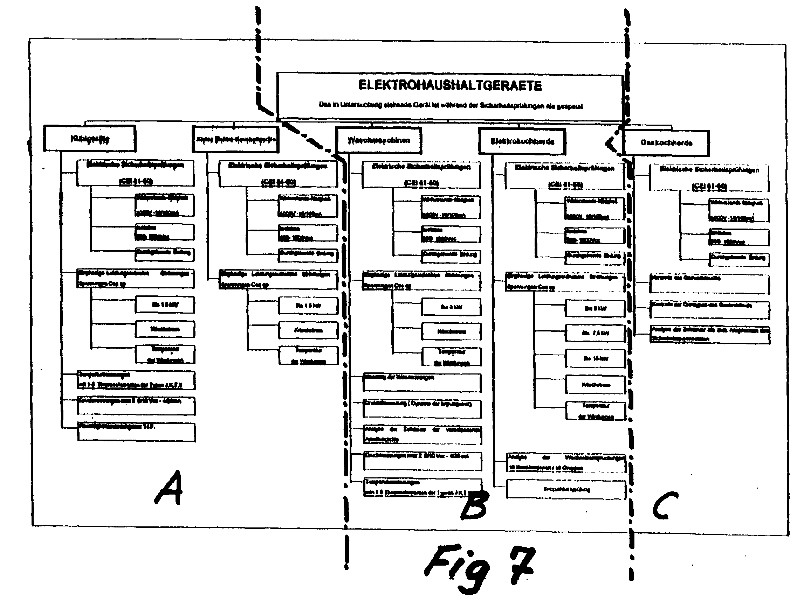

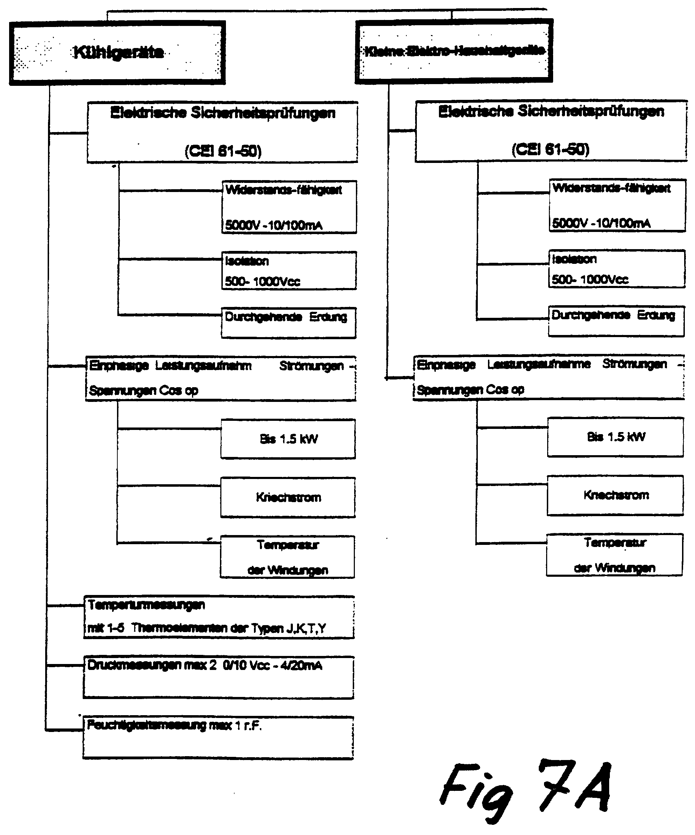

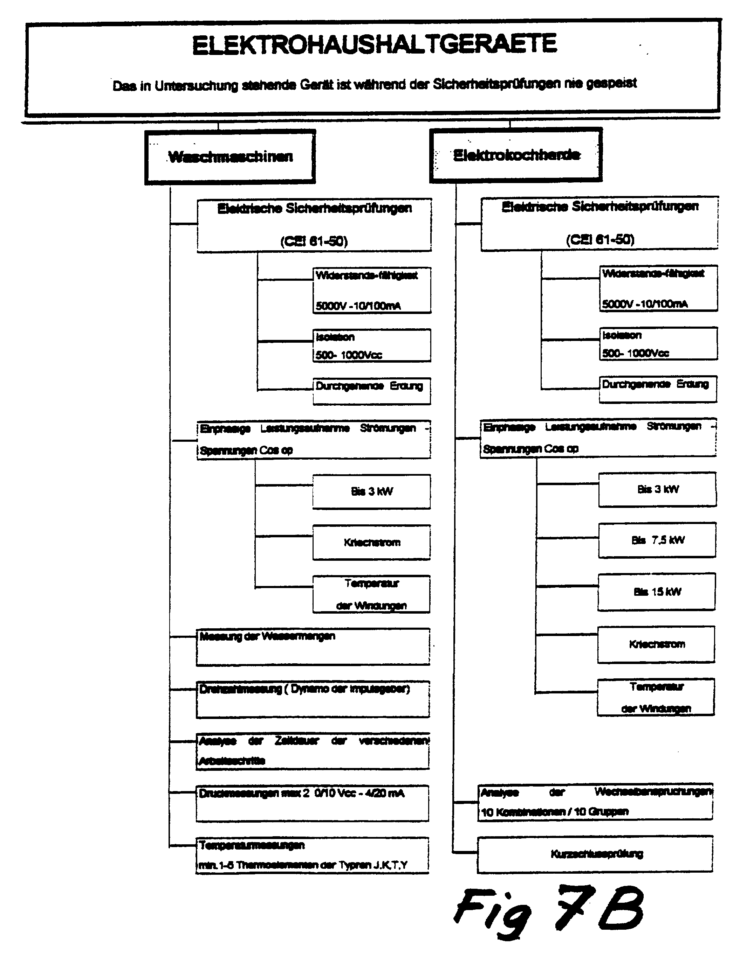

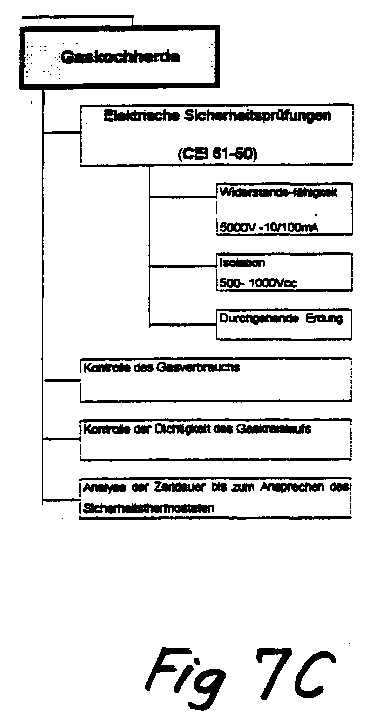

Zum Schluss seien, ebenfalls lediglich im Sinn eines Beispiels, zwei Schemen der in praktischer Anwendung realisierten Operationen aufgezeigt: Das erste Beispiel, das in der Fig. 7 dargestellt ist, zeigt die für die Kontrolle und die Ueberprüfung von Elektro-Haushaltgeräten vorgesehenen Operationen. Aus dem Schema ist ersichtlich, wie die auszuführenden Operationen entsprechend den Typen der auf der Fabrikationslinie hergestellten Elektro-Haushaltgeräte variieren. Auf diese Weise werden beispielsweise für die Kontrolle und die Prüfung eines Kühlschrankes fünf hauptsächliche KontrollOperationen vorgesehen (Vgl. die erste Kolonne links in dem in der Fig. 7 dargestellten Beispiel), während für ein kleines Elektro-Haushaltgerät (wie beispielsweise ein Mixer) normalerweise zwei Arten von Kontrollen genügen; bei einer Waschmaschine hingegen, die einen hydraulischen sowie einen mechanischen Teil umfasst, sind sieben hauptsächliche Kontroll-Operationen erforderlich, usw. Dank der grossen Vielseitigkeit der erfindungsgemässen Vorrichtung zur Messung und Prüfung, d.h. dank der zahllosen Möglichkeiten, die Module auszuwechseln und die Operationen zu programmieren, können alle diese Kontrollen und Prüfungen nach Bedarf für die verschiedenen Arten von Elektro-Haushaltgeräten mit Hilfe der gleichen erfindungsgemässen Vorrichtung durchgeführt werden, die in geeigneter Weise angepasst wird, und falls sie eine genügende Zahl von Modulen aufweist, lediglich noch von der Bedienungsperson zu programmieren ist.

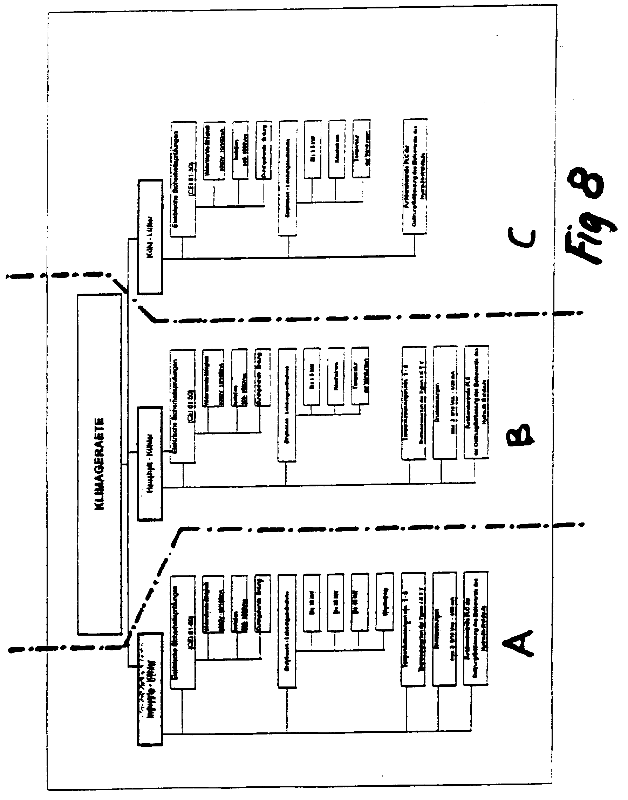

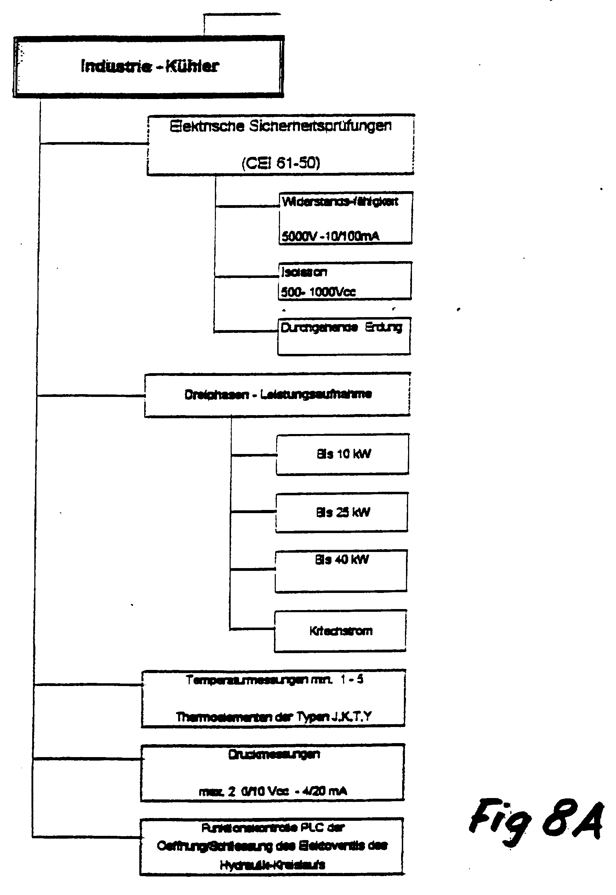

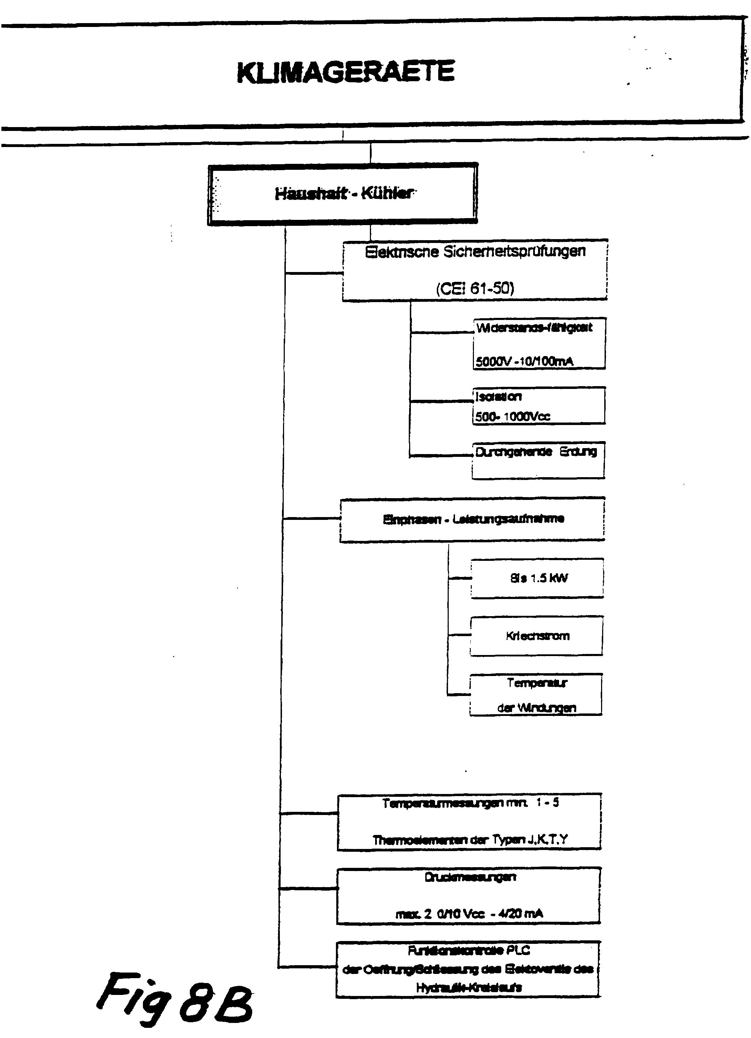

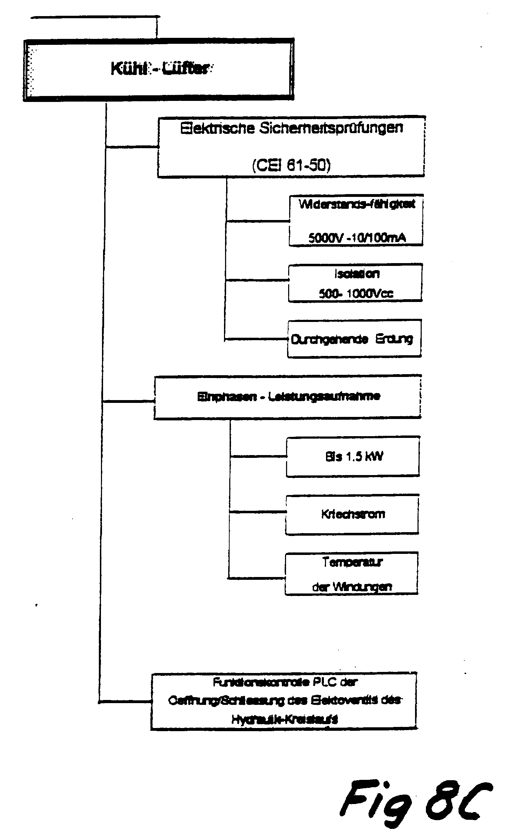

In der Fig. 8 ist ein weiteres Anwendungsbeispiel einer Vorrichtung zur Messung und Prüfung in einem Schema dargestellt, das die besonderen Operationen für Klimageräte zeigt. Selbstverständlich stellen die Beispiele gemäss den Figuren 7 und 8 lediglich Hinweise dar, und im Rahmen der vorliegenden Erfindung könnten die Beispiele beliebig vermehrt werden, womit die Erfindung ihre grossen Anwendungsmöglichkeiten in den verschiedensten Industriebereichen aufzeigt.

### LISTE DER IN DEN FIGUREN DARGESTELLTEN ELEMENTE

- 1: Transportband
- 2: Elektro-Haushaltgerät
- 3: Mess- und Abnahme-Prüfvorrichtung
- 4: Leiter
- 5: Kontroll- und Programmierungs-Einheit
- 6: Verpackungs-Station
- 7: Ausschuss-Transportband
- 8: Mess-Ausgang oder Modul
- 9: Leistunsgsteil
- 10: Mikroprozessor (LCD)
- 11: Drucker-Einheit
- 12: Aufnahmestation für die Einheiten 8
- 13: Personal Computer (PC)
- 14: Verbindungsleitungen
- 15: Abnahme-Prüfgerät
- 16: Abnahme-Prüfgerät

## Patentansprüche

1. Vorrichtung zur Messung und zur Prüfung für die Durchführung von Messungen bezüglich elektrischer Sicherheit und Funktionsprüfungen elektrischer Apparate, insbesondere von Elektro-Hausshaltgeräten, längs der Montagelinie der Fabrikation oder am Ende der Montagelinie, die eine Steuerungs- und Programmierungs-Einheit enthält sowie eine Anzahl Messeinheiten, von denen jede mindestens eine bestimmte Messung undloder Prüfung ausführen kann, sowie einen Leistungsteil zur Speisung jedes einzelnen Messgerätes mit passendem elektrischen Strom,
**dadurch gekennzeichnet, dass**
die Messeinheiten (8) als austauschbare Module ausgebildet und mit Anschluss-Systemen (14) versehen sind, die raschen Anschluss der Module an die Vorrichtung (3) zur Messung und Prüfung sowie deren Auswechselbarkeit innerhalb der gleichen oder mit separaten anderen Vorrichtungen zur Messung und Prüfung erlauben.

2. Vorrichtung gemäss dem Anspruch 1,
**dadurch gekennzeichnet, dass**
jedes einzelne Modul (8) mindestens eine der folgenden Messungen und Prüfungen ausführen kann:
- Dielektrische Widerstandsfähigkeit,
- Isolation und durchgehende Wirksamkeit der Erdung,
- Ein- und/oder dreiphasige Leistungsaufnahme mit Ablesung der Kriechströme,
- Elektrischer Widerstand,
- Verschiedene elektrische und physikalische Grössen (Druck, Temperatur, Zeitdauern, usw.) mittels Uebertragungselementen.

3. Vorrichtung gemäss dem Anspruch 1,
**dadurch gekennzeichnet, dass**
die Steuerungs- und Programmierungs-Einheit (5) ein Mikroprozessor (LCD) (10) ist.

4. Vorrichtung gemäss dem Anspruch 1,
**dadurch gekennzeichnet, dass**
die Steuerungs- und Programmierungs-Einheit (5) aus einem Personal Computer (PC) (13) besteht.

5. Vorrichtung gemäss dem Anspruch 1,
**dadurch gekennzeichnet, dass**
diese eine Anzahl Module (8) enthält, die zwischen vier und 32 liegt.

6. Vorrichtung gemäss dem Anspruch 1,
**dadurch gekennzeichnet, dass**
in der gleichen Vorrichtung gleichzeitig mehr als ein Modul (8) des gleichen Typs verwendet werden können.

7. Vorrichtung gemäss dem Anspruch 2,
**dadurch gekennzeichnet, dass**
das Modul für die Prüfung der elektrischen Widerstandsfähigkeit die folgenden Elemente umfasst:
- eingebauter Mikroprozessor mit seriellem Anschluss,
- serieller Anschluss zur Verbindung mit einer Tastatur oder mit einem PC,
- Eq PROM zur Speicherung von Tarierungs-Parametern,
- Leistungs-Karte mit
. Potentiometer-Steuerung,
. Hochspannungs-Transformer,
. entsprechenden TA und TV,
. PWM-Verstärker.

8. Vorrichtung gemäss dem Anspruch 2,
**dadurch gekennzeichnet, dass**
das Modul für die Prüfung der Isolation und der durchgehenden Wirksamkeit der Erdung die folgenden Elemente umfasst bzw. die folgenden Eigenschaften aufweist:
- eingebauter Mikroprozessor mit seriellem Anschluss,
- verstellbare Spannung 250-500-1000 Vcc,
- vier verschiedene Spannungs- und Strombereiche,
- Gleichstromgenerator,
- TA-Steuerung und Differential-Verstärker.

9. Vorrichtung gemäss dem Anspruch 2,
**dadurch gekennzeichnet, dass**
das Modul für die Prüfung der ein- undloder dreiphasigen Leistungsaufnahme mit Ablesung des Kriechstroms die folgenden Elemente umfasst bzw. die folgenden Eigenschaften aufweist:
- eingebauter Mikroprozessor mit seriellem Anschluss,
- in vier Bereichen einstellbare Spannung,
- vier verschiedene Spannungs- und Strombereiche,
- Spannungs-Stabilisator,
- Steuerung mit drei Potentiometern,
- Ablesung von vier Stromwerten und von drei Spannungswerten,
- Leistungs-VI cos ϕ für jede Phase mit Summierung für das dreiphasige System.

10. Vorrichtung gemäss dem Anspruch 2,
**dadurch gekennzeichnet, dass**
das Modul für die Messung des elektrischen Widerstandes die folgenden Elemente umfasst bzw. die folgenden Eigenschaften aufweist:
- eingebauter Mikroprozessor mit seriellem Anschluss,
- gleichzeitige Messung von zwei Widerständen,
- vier verschiedene Spannungs- und Strombereiche,
- automatische Bereichseinstellung (Autorange),
- automatische Ersatz-Tarierung und Verstärkung,
- Stromgenerator.

11. Vorrichtung gemäss dem Anspruch 2,
**dadurch gekennzeichnet, dass**
das Modul für die Messung verschiedener elektrischer und physikalischer Grössen die folgenden Elemente umfasst bzw. die folgenden Eigenschaften aufweist:
- eingebauter Mikroprozessor mit seriellem Anschluss,
- sechzehn zuweisbare Analog-Eingänge,
- vier zuweisbare Analog-Ausgänge,
- sechzehn optisch isolierte Digital-Eingänge,
- sechzehn + sechzehn optisch isolierte Digital-Ausgänge,
- Summer.
